# EUROPEAN PATENT APPLICATION

(11) **EP 4 401 155 A1**
(43) Date of publication of application: **17.07.2024**
(21) Application number: 22866584.0
(22) Date of filing: 06.09.2022
(51) Int. Cl.: H01L 31/18, H01L 31/0216, H01L 31/042

(54) **BATTERY BACK PASSIVATION STRUCTURE, MANUFACTURING METHOD THEREFOR, AND SOLAR CELL**

(30) Priority: 09.09.2021 CN 202111056381
(71) Applicant: CHINT New Energy Technology Co., Ltd., Haining, Zhejiang 314400 (CN)
(72) Inventor: LI, Hongbo, Zhejiang 314400 (CN); HE, Sheng, Zhejiang 314400 (CN); HSU, Wei-chih, Zhejiang 314400 (CN); SHAN, Wei, Zhejiang 314400 (CN)
(74) Representative: PGA S.p.A., Milano, Succursale di Lugano
(86) International application number: PCT/CN2022/117237
(87) International publication number: WO 2023/036121

(57) **Abstract**

A battery back passivation structure, a manufacturing method therefor, and a solar cell, the manufacturing method comprising: introducing a dopant gas and a first reaction gas into a coating device, and depositing a doped passivation layer on the back side of a silicon wafer (1); and introducing a second reaction gas into the coating device, and directly or indirectly depositing an internal reflection layer on the surface of the doped passivation layer away from the silicon wafer (1). The described battery back passivation structure comprises a doped passivation layer and an internal reflection layer that are stacked on the back side of the silicon wafer (1), and has enhanced passivation capability.

## Description

This application claims priority to Chinese Patent Application No. 202111056381.1, titled "BACKSIDE PASSIVATION STRUCTURE OF BATTERY CELL, METHOD FOR MANUFACTURING THE SAME, AND SOLAR CELL", filed on September 9, 2021 with the China National Intellectual Property Administration, which is incorporated herein by reference in its entirety.

### FIELD

The present disclosure relates to the field of photovoltaic technology, and in particular, to a backside passivation structure of a battery cell, a method for manufacturing the backside passivation structure, and a solar cell.

### BACKGROUND

A solar battery/cell is a device capable of converting solar energy into electric energy. Backside passivation techniques have emerged for improving efficiency of the solar cells. At present, the backside passivation structure of solar cells is formed through depositing an aluminum oxide film or a silicon oxynitride film on a back surface of a silicon wafer. A single layer of the backside passivation film has poor performances in passivation, and the silicon oxynitride film is thick, which results in great time consumption and low efficiency in manufacturing. Meanwhile, defects such as wrap plating and a backside-field ship mark are introduced.

Therefore, a focus of those skilled in the art is how to address the above technical issues.

### SUMMARY

An objective of the present disclosure is providing a backside passivation structure of a battery cell, a method for manufacturing the backside passivation structure, and a solar cell. Passivation performances of the backside passivation structure are improved, a process of manufacture consumes less time, and a yield of the batteries is improved.

In order to address at least the above technical issues, a method for manufacturing a backside passivation structure of a battery cell is provided according to embodiments of the present disclosure. The method comprises: depositing a doped passivation layer on a back surface of a silicon wafer, through injecting a dopant gas and a first reaction gas into a coating device; and depositing an internal reflection layer directly or indirectly on a surface of the doped passivation layer away from the silicon wafer, through injecting a second reaction gas into the coating device.

In an embodiment, after depositing the doped passivation layer on the back side of the silicon wafer, the method further comprises: depositing a silicon oxynitride layer at the surface of the doped passivation layer away from the silicon wafer, through injecting the first reaction gas into the coating device. Correspondingly, depositing the internal reflection layer directly or indirectly on the surface of the doped passivation layer away from the silicon wafer comprises: depositing the internal reflection layer on a surface of the silicon oxynitride layer away from the doped passivation layer.

In an embodiment, the first reaction gas comprises SiH₄, NH₃, and N₂O, and the doped passivation layer is a doped silicon oxynitride layer. The second reaction gas comprises SiH₄ and NH₃, and the internal reflection layer is a silicon nitride layer.

In an embodiment, depositing the internal reflection layer on the surface of the silicon oxynitride layer away from the doped passivation layer comprises: depositing multiple internal reflection layers sequentially stacked on the surface of the silicon oxynitride layer away from the doped passivation layer, where the dopant gas comprises a gas comprising phosphorus, boron, aluminum, gallium, or indium.

In an embodiment, a refractive index decreases gradually along a direction pointing away from the silicon wafer among the multiple internal reflection layers.

In an embodiment, a quantity of the internal reflection layers is three.

In an embodiment, a first internal reflection layer, a second internal reflection layer, and a third internal reflection layer are arranged along the direction pointing away from the silicon oxynitride layer. The refractive index of the first internal reflection layer ranges from 2.35 to 2.25, and a thickness of the first internal reflection layer ranges from 10nm to 35nm. The refractive index of the second internal reflection layer ranges from 2.1 to 2.25, and a thickness of the second internal reflection layer ranges from 10nm to 20nm. The refractive index of the third internal reflection layer ranges from 1.9 to 2.1, and a thickness of the third internal reflection layer ranges from 10nm to 20nm.

In an embodiment, a fixed negative charge density at a surface of the doped silicon oxynitride layer is greater than or equal to 1×10¹²cm⁻², a content of hydrogen in the doped silicon oxynitride layer ranges from 18 to 30 in atomic percentage.

In an embodiment, before depositing the doped passivation layer on the back surface of the silicon wafer through injecting the dopant gas and the first reaction gas into the coating device, the method further comprises: polishing the silicon wafer by using an acid solution or an alkali solution.

A backside passivation structure of a battery cell is further provided according to embodiments of the present disclosure. The backside passivation structure is manufactured through any foregoing method.

A solar cell is further provided according to embodiments of the present disclosure. The solar cell comprises the foregoing backside passivation structure.

Thereby, the method for manufacturing the backside passivation structure of the battery cell is provided according to embodiments of the present disclosure. The method comprises: injecting the dopant gas and the first reaction gas into the coating device to deposit the doped passivation layer on the back surface of the silicon wafer; and injecting the second reaction gas into the coating device to deposit the internal reflection layer directly or indirectly on the surface of the doped passivation layer away from the silicon wafer.

Hence, the backside passivation structure of the battery cell according to embodiments of the present disclosure comprises the doped passivation layer and the internal reflection layer which are stacked on the back surface of the silicon wafer, and has improved passivation performances. Herein the doped passivation layer is deposited through injecting the dopant gas and the first reaction gas simultaneously into the coating device, that is, the doped passivation layer is obtained in a single step. Such process is not first depositing a passivation layer and then doping the passivation layer through diffusion or ion implantation. Hence, time consumed by fabricating the doped passivation layer is reduced, and the passivation layer is protected from damages, which are induced by the diffusion or the ion implantation process and affect performances of the backside passivation structure. Since the obtained doped passivation layer has good passivation performances, a thickness of the doped passivation layer may be reduced, which further reduces time consumed by fabricating the doped passivation layer. Thereby, defects such as wrap plating and a back-side field ship mark are suppressed.

In addition, the backside passivation structure and the solar cell having the above advantages are also provided according to embodiments of the present disclosure.

### BRIEF DESCRIPTION OF THE DRAWINGS

Hereinafter drawings to be applied in embodiments of the present disclosure or in conventional technology are briefly described, in order to clarify illustration of technical solutions according to embodiments of the present disclosure or in conventional technology. Apparently, the drawings in the following descriptions are only some embodiments of the present disclosure, and other drawings may be obtained by those skilled in the art based on the provided drawings without exerting creative efforts.
Figure 1 is a flowchart of a method for manufacturing a backside passivation structure of a battery cell according to an embodiment of the present disclosure.
Figure 2 is a flowchart of a method for manufacturing a backside passivation structure of a battery cell according to another embodiment of the present disclosure.
Figure 3 is a schematic diagram of a backside passivation structure of a battery cell according to an embodiment of the present disclosure.

### DETAILED DESCRIPTION OF EMBODIMENTS

In order to facilitate those skilled in the art understanding the present disclosure, hereinafter technical solutions of the present disclosure are further described in detail in conjunction with the drawings and embodiments of the present closure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

Many specific details are illustrated in following description to facilitate full understanding of the present disclosure. The present disclosure may be implemented in a manner other than those described herein. Those skilled in the art can make deduction by analogy without departing from the scope of the present disclosure. Therefore, the present disclosure is not limited to specific embodiments disclosed hereinafter.

As described in the background, conventional backside passivation structures of solar cells are formed through depositing an aluminum oxide film or a silicon oxynitride film on a back surface of a silicon wafer. A single layer of the backside passivation film has poor performances in passivation, and the silicon oxynitride film is thick, which results in great time consumption and low efficiency in manufacturing. Meanwhile, defects such as wrap plating and a backside-field ship mark are introduced.

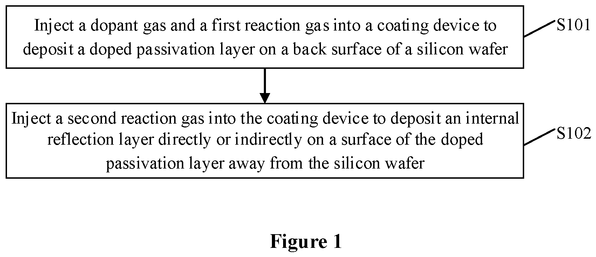

In view of at least the above, a method for manufacturing a backside passivation structure of a battery cell is provided according to embodiments of the present disclosure. Reference is made to Figure 1, which is a flowchart of a method for manufacturing a backside passivation structure of a battery cell according to an embodiment of the present disclosure. The method comprises steps S101 and S102.

In step S101, a dopant gas and a first reaction gas are injected into a coating device to deposit a doped passivation layer on a back surface of a silicon wafer.

Generally, the doped passivation layer may be deposited through plasma enhanced chemical vapor deposition (PECVD), so as to ensure a performance of the doped passivation layer. Correspondingly, the coating device is a PECVD device.

A type of PECVD device is not specifically limited herein and may be determined based on an actual situation. For example, the PECVD device may be a plane-cathode PECVD device or a tube PECVD device.

A dopant element required in the doped passivation layer is provided in the dopant gas. A type of the dopant gas depends on the doping element.

The first reaction gas refers to a gas required for depositing an undoped passivation layer. A type of the first reaction gas depends on a material of the passivation layer.

Herein a material of the doped passivation layer is not specifically limited and may be determined based on an actual situation. For example, the doped passivation layer may be a doped silicon nitride layer or a doped silicon oxynitride layer. In an embodiment, it is not necessary to deposit an aluminum oxide layer. That is, it is not necessary to perform atomic layer deposition for fabricating the aluminum oxide layer, and only the PECVD is performed. Thereby, duration in which a semi-manufactured product of the backside passivation structure stays in factory is shortened, and the fragmentation and other defects introduced during the processing are reduced.

In an embodiment, the doped passivation layer is a doped silicon oxynitride layer. A fixed negative charge density at a surface of a doped silicon nitride layer may approximate 1×10¹²cm⁻², and a fixed negative charge density at a surface of the doped silicon oxynitride may be greater than or equal to 1×10¹³cm⁻². After being annealed at a temperature higher than 400°C, the fixed negative charge density of the doped silicon nitride annealed may approximate 1× 10¹¹cm⁻². After being annealed at a temperature higher than 700°C, the fixed negative charge density of doped silicon oxynitride annealed may be greater than or equal to about 1×10¹²cm⁻². A reason lies that an oxygen-rich film has larger intermediate bandgap, a larger density of interface traps, and a higher fixed charge density at an interface, in comparison with a nitrogen-rich film. The doped (n-doped) silicon oxynitride layer has denser fixed negative charges and a longer minority carrier lifetime in comparison with the doped (n-doped) silicon nitride layer, and hence improves a performance of the backside passivation structure in the battery cell. In such case, the first reaction gas may comprise SiH₄, NH₃ and N₂O. The second reaction gas may comprise SiH₄ and NH₃, and the internal reflection layer is a silicon nitride layer.

Alternatively, the doped passivation layer may be the doped silicon nitride layer, and the first reaction gas comprises SiH₄ and NH₃.

Compared to an aluminum oxide layer, the doped silicon oxynitride layer comprises more hydrogen, which improves the passivation performances. The doped silicon oxynitride layer has advantages of both aluminum oxide and silicon oxynitride in surface passivation, and hence a performance of surface passivation is better. Compared to a single-layer silicon oxynitride, the doped silicon oxynitride layer has a better performance of field passivation. Thereby, efficiency of solar cells can be improved.

The doping elements are not limited herein, and may depend on an actual situation. For example, the doping element may be an element of the III-A group, for example, boron, aluminum, gallium, and indium, or an element of the V-A group, for example, phosphorus and arsenic. Correspondingly, the dopant gases may be B₂H₆, trimethylaluminum (TMA), trimethylgallium (TMGa), PH₃, or the like. The dopant gas would not introduce an element other than the required doping element into the doped passivation layer.

In step S102, a second reaction gas is injected into the coating device to deposit an internal reflection layer directly or indirectly on a surface of the doped passivation layer away from the silicon wafer.

Direct deposition refers to that the internal reflection layer is deposited directly on the surface of the doped passivation layer away from the silicon wafer after the doped passivation layer has been deposited. Indirect deposition refers to that after the doped passivation layer has been deposited, a silicon oxynitride layer is first deposited on the surface of the doped passivation layer away from the silicon wafer, and then the internal reflection layer is deposited on a surface of the silicon oxynitride layer, which would be described later. Generally, the internal reflection layer is a silicon nitride layer. Correspondingly, the second reaction gas may comprise SiH₄ and NH₃.

A quantity of internal reflection layer(s) may be one or more, which is not limited herein.

Thereby, the backside passivation structure of the battery cell according to embodiments of the present disclosure comprises the doped passivation layer and the internal reflection layer which are stacked on the back surface of the silicon wafer, and has improved passivation performances. Herein the doped passivation layer is deposited through injecting the dopant gas and the first reaction gas simultaneously into the coating device, that is, the doped passivation layer is obtained in a single step. Such process is not first depositing a passivation layer and then doping the passivation layer through diffusion or ion implantation. Hence, time consumed by fabricating the doped passivation layer is reduced, and the passivation layer is protected from damages, which are induced by the diffusion or the ion implantation process and affect performances of the backside passivation structure. Since the obtained doped passivation layer has good passivation performances, a thickness of the doped passivation layer may be reduced, which further reduces time consumed by fabricating the doped passivation layer. Thereby, defects such as wrap plating and a back-side field ship mark are suppressed.

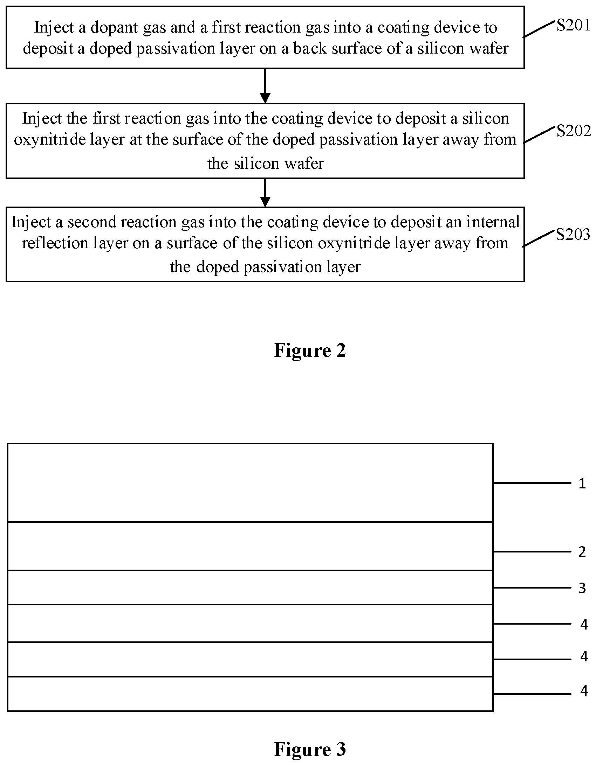

Reference is made to Figure 2, which is a flowchart of a method for manufacturing a backside passivation structure of a battery cell according to another embodiment of the present disclosure. The method comprises steps S201 to S203.

In step S201, a dopant gas and a first reaction gas are injected into a coating device to deposit a doped passivation layer on a back surface of a silicon wafer.

In this step, the doped passivation layer may be a doped silicon oxynitride layer.

In step S202, the first reaction gas is injected into the coating device to deposit a silicon oxynitride layer at the surface of the doped passivation layer away from the silicon wafer.

In this embodiment, a layer of silicon oxynitride is deposited between the doped silicon oxynitride layer and the internal reflection layer. Compared to a silicon-nitride alloy system, a phosphorus-doped silicon oxynitride is more complicated due to comprising, for example, P-H bonds besides Si-H bonds and N-H bonds. Content of hydrogen (H) in the doped silicon oxynitride may range from 18 atomic percentages (at. %) to 30 at. %, which is significantly higher than that in the doped silicon nitride, i.e., ranging between 15 at. % to 25 at. %. The rich hydrogen in doped silicon oxynitride diffuses into the silicon wafer under high-energy processing, such as under a high temperature or under electric injection, and hence deactivates defects through combining with defect centers. Moreover, the hydrogen can neutralize dangling bonds at the surface of the silicon wafer. Thereby, stronger hydrogen passivation can be achieved at a surface and a bulk of the silicon wafer, which improves efficiency of solar cells. When the doped silicon oxynitride layer is thin, a certain degree of surface passivation is also provided.

A film for front-surface passivation and antireflection requires both good performances of surface passivation and a capability of minimizing light reflection. Hence, materials having lower reflectivity are desired. A range within which a refractive index of the doped silicon oxynitride layer is adjustable is lower than that for the doped silicon nitride layer. A refractive index of the doped silicon oxynitride layer may be controlled to range from 1.4 to 1.8, and a thickness of the doped silicon oxynitride layer ranges from 10nm to 50nm. A refractive index of the silicon oxynitride layer may be controlled to range from 1.6 to 1.9, and a thickness of the silicon oxynitride layer ranges 10nm to 20nm.

In step S203, a second reaction gas is injected into the coating device to deposit an internal reflection layer on a surface of the silicon oxynitride layer away from the doped passivation layer.

In an embodiment, depositing the internal reflection layer on the surface of the silicon oxynitride layer away from the doped passivation layer comprises a following step.

Multiple internal reflection layers, which are sequentially stacked, are deposited on the surface of the silicon oxynitride layer away from the doped passivation layer. The dopant gas comprises a gas comprising phosphorus, boron, aluminum, gallium, or indium.

The refractive index decreases gradually among the multiple internal reflection layers along a direction pointing away from the silicon wafer. The passivation performances of the backside passivation structure can be improved, reflectivity at the back surface can be reduced. That is, an effect of antireflection of the internal reflection layer and an effect of passivating the back surface are improved. The internal reflection layer that is farthest away from the surface of the silicon oxynitride layer has the largest refractive index. Thereby, a better passivation effect is achieved at the back surface, and an open-circuit voltage of the solar cells can be increased.

A quantity of the internal reflection layers may be, but is not limited to, three, four, five, or the like.

In a case that the quantity of the internal reflection layers is three, the internal reflection layers are configured as follows along the direction pointing away from the silicon oxynitride layer. The first internal reflection layer has a refractive index ranging from 2.35 to 2.25 and a thickness ranging from 10nm to 35nm. The second internal reflection layer has a refractive index ranging from 2.25 to 2.1 and a thickness ranging from 10nm to 20nm. The third internal reflection layer has a refractive index ranging from 2.1 to 1.9 and a thickness ranging from 10nm to 20nm. A schematic structural diagram of the backside passivation structure having three internal reflection layers may be as shown in Figure 3. The backside passivation structure comprises a silicon wafer 1, a doped silicon oxynitride layer 2, a silicon oxynitride layer 3, and three stacked silicon nitride layers 4, which are arranged sequentially from top to bottom.

In an embodiment on a basis of any foregoing embodiment, the method further comprises a following step before the dopant gas and the first reaction gas are injected into the coating device to deposit the doped passivation layer on the back surface of the silicon wafer.

The silicon wafer is polished by using an acid solution or an alkali solution, so as to remove damages at the surface of the silicon wafer.

Those skilled in the art have the knowledge of acid polishing techniques and alkali polishing techniques, which would not be described in detail here.

Hereinafter it is taken as examples that different dopant elements and the PECVD approach are adopted in the method for manufacturing the backside passivation structure of the battery cell.

### First Example

In step 1, the silicon wafer is polished and etched with an acid solution.

In step 2, four gases, which are PH₃, SiH₄, NH₃, and N₂O, respectively, are injected into a PECVD device to fabricate a phosphorus-doped silicon oxynitride layer. A refractive index of the phosphorus-doped silicon oxynitride layer is controlled to range from 1.4 to 1.8, and a thickness of the phosphorus-doped silicon oxynitride layer is controlled to range from 10nm to 50nm;

In step 3, a silicon oxynitride layer is deposited on a surface of the phosphorus-doped silicon oxynitride layer by using three gases, which are SiH₄, NH₃, and N₂O, respectively. A refractive index of the silicon oxynitride layer is controlled to range from 1.6 to 1.9, and a thickness of the silicon oxynitride layer is controlled to range from 10nm to 20nm;

In step 4, a first silicon nitride layer is fabricated on a surface of the silicon oxynitride layer by using two gases, which are SiH₄ and NH₃, respectively. A refractive index of the first silicon nitride layer is controlled to range from 2.25 to 2.35, and a thickness of the first silicon nitride layer is controlled to range from 10nm to 35nm.

In step 5, a second silicon nitride layer is fabricated on a surface of the first silicon nitride layer by using two gases, which are SiH₄ and NH₃, respectively. A refractive index of the second silicon nitride layer is controlled to range from 2.1 to 2.25, and a thickness of the second silicon nitride layer is controlled to range from 10nm to 20nm.

In step 6, a third silicon nitride layer is fabricated on a surface of the second silicon nitride layer by using two gases, which are SiH₄ and NH₃, respectively. A refractive index of the third silicon nitride layer is controlled to range from 1.9 to 2.1, and a thickness of the third silicon nitride layer is controlled to range from 10nm to 20nm.

### Second Example

In step 1, the silicon wafer is polished and etched with an acid solution.

In step 2, four gases, which are B₂H₆, SiH₄, NH₃, and N₂O, respectively, are injected into a PECVD device to fabricate a boron-doped silicon oxynitride layer. A refractive index of the boron-doped silicon oxynitride layer is controlled to range from 1.4 to 1.8, and a thickness of the boron-doped silicon oxynitride layer is controlled to range from 10nm to 50nm;

In step 3, a silicon oxynitride layer is deposited on a surface of the boron-doped silicon oxynitride layer by using three gases, which are SiH₄, NH₃, and N₂O, respectively. A refractive index of the silicon oxynitride layer is controlled to range from 1.6 to 1.9, and a thickness of the silicon oxynitride layer is controlled to range from 10nm to 20nm;

In step 4, a first silicon nitride layer is fabricated on a surface of the silicon oxynitride layer by using two gases, which are SiH₄ and NH₃, respectively. A refractive index of the first silicon nitride layer is controlled to range from 2.25 to 2.35, and a thickness of the first silicon nitride layer is controlled to range from 10nm to 35nm.

In step 5, a second silicon nitride layer is fabricated on a surface of the first silicon nitride layer by using two gases, which are SiH₄ and NH₃, respectively. A refractive index of the second silicon nitride layer is controlled to range from 2.1 to 2.25, and a thickness of the second silicon nitride layer is controlled to range from 10nm to 20nm.

In step 6, a third silicon nitride layer is fabricated on a surface of the second silicon nitride layer by using two gases, which are SiH₄ and NH₃, respectively. A refractive index of the third silicon nitride layer is controlled to range from 1.9 to 2.1, and a thickness of the third silicon nitride layer is controlled to range from 10nm to 20nm.

### Third Example

In step 1, the silicon wafer is polished and etched with an acid solution.

In step 2, four gases, which are TMGa, SiH₄, NH₃, and N₂O, respectively, are injected into a PECVD device to fabricate a gallium-doped silicon oxynitride layer. A refractive index of the gallium-doped silicon oxynitride layer is controlled to range from 1.4 to 1.8, and a thickness of the gallium-doped silicon oxynitride layer is controlled to range from 10nm to 50nm;

In step 3, a silicon oxynitride layer is deposited on a surface of the gallium-doped silicon oxynitride layer by using three gases, which are SiH₄, NH₃, and N₂O, respectively. A refractive index of the silicon oxynitride layer is controlled to range from 1.6 to 1.9, and a thickness of the silicon oxynitride layer is controlled to range from 10nm to 20nm;

In step 4, a first silicon nitride layer is fabricated on a surface of the silicon oxynitride layer by using two gases, which are SiH₄ and NH₃, respectively. A refractive index of the first silicon nitride layer is controlled to range from 2.25 to 2.35, and a thickness of the first silicon nitride layer is controlled to range from 10nm to 35nm.

In step 5, a second silicon nitride layer is fabricated on a surface of the first silicon nitride layer by using two gases, which are SiH₄ and NH₃, respectively. A refractive index of the second silicon nitride layer is controlled to range from 2.1 to 2.25, and a thickness of the second silicon nitride layer is controlled to range from 10nm to 20nm.

In step 6, a third silicon nitride layer is fabricated on a surface of the second silicon nitride layer by using two gases, which are SiH₄ and NH₃, respectively. A refractive index of the third silicon nitride layer is controlled to range from 1.9 to 2.1, and a thickness of the third silicon nitride layer is controlled to range from 10nm to 20nm.

### Fourth Example

In step 1, the silicon wafer is polished and etched with an acid solution.

In step 2, four gases, which are TMA, SiH₄, NH₃, and N₂O, respectively, are injected into a PECVD device to fabricate an aluminum-doped silicon oxynitride layer. A refractive index of the aluminum-doped silicon oxynitride layer is controlled to range from 1.4 to 1.8, and a thickness of the aluminum-doped silicon oxynitride layer is controlled to range from 10nm to 50nm;

In step 3, a silicon oxynitride layer is deposited on a surface of the aluminum-doped silicon oxynitride layer by using three gases, which are SiH₄, NH₃, and N₂O, respectively. A refractive index of the silicon oxynitride layer is controlled to range from 1.6 to 1.9, and a thickness of the silicon oxynitride layer is controlled to range from 10nm to 20nm;

In step 4, a first silicon nitride layer is fabricated on a surface of the silicon oxynitride layer by using two gases, which are SiH₄ and NH₃, respectively. A refractive index of the first silicon nitride layer is controlled to range from 2.25 to 2.35, and a thickness of the first silicon nitride layer is controlled to range from 10nm to 35nm.

In step 5, a second silicon nitride layer is fabricated on a surface of the first silicon nitride layer by using two gases, which are SiH₄ and NH₃, respectively. A refractive index of the second silicon nitride layer is controlled to range from 2.1 to 2.25, and a thickness of the second silicon nitride layer is controlled to range from 10nm to 20nm.

In step 6, a third silicon nitride layer is fabricated on a surface of the second silicon nitride layer by using two gases, which are SiH₄ and NH₃, respectively. A refractive index of the third silicon nitride layer is controlled to range from 1.9 to 2.1, and a thickness of the third silicon nitride layer is controlled to range from 10nm to 20nm.

A backside passivation structure of a battery cell is further provided according to an embodiment of the present disclosure. The backside passivation structure is manufactured through the method for manufacturing the backside passivation structure according to any foregoing embodiment.

The backside passivation structure of the battery cell according to embodiments of the present disclosure comprises the doped passivation layer and the internal reflection layer which are stacked on the back surface of the silicon wafer, and has improved passivation performances. Herein the doped passivation layer is deposited through injecting the dopant gas and the first reaction gas simultaneously into the coating device, that is, the doped passivation layer is obtained in a single step. Such process is not first depositing a passivation layer and then doping the passivation layer through diffusion or ion implantation. Hence, time consumed by fabricating the doped passivation layer is reduced, and the passivation layer is protected from damages, which are induced by the diffusion or the ion implantation process and affect performances of the backside passivation structure. Since the obtained doped passivation layer has good passivation performances, a thickness of the doped passivation layer may be reduced, which further reduces time consumed by fabricating the doped passivation layer. Thereby, defects such as wrap plating and a back-side field ship mark are suppressed.

A solar cell is further provided according to an embodiment of the present disclosure. The solar cell comprises the backside passivation structure in the foregoing embodiment.

The solar cell may be a double-side passivated emitter rear contact (PERC) cell, a passivated emitter and rear locally-diffused (PERL) cell, or the like.

The embodiments of the present disclosure are described in a progressive manner, and each embodiment places emphasis on the difference from other embodiments. Therefore, one embodiment can refer to other embodiments for the same or similar parts. Since apparatuses disclosed herein correspond to the methods disclosed in the embodiments, the description of the apparatuses is simple, and reference may be made to the relevant part of the methods.

Hereinabove the backside passivation structure of the battery cell, the method for manufacturing the backside passivation structure, and the solar cell are provided and illustrated in detail according to embodiment of the present disclosure. Specific examples are used herein to explain principles and the embodiments of the present disclosure. Description of the above embodiments is merely intended for helping understand the method and a core concept of the present disclosure. Those skilled in the art may make several improvements and modifications to the present disclosure without departing from the principles of the present disclosure. These improvements and modifications shall fall within the protection scope of the claims of the present disclosure.

## Claims

1. A method for manufacturing a backside passivation structure of a battery cell, comprising:
depositing a doped passivation layer on a back surface of a silicon wafer, through injecting a dopant gas and a first reaction gas into a coating device; and
depositing an internal reflection layer directly or indirectly on a surface of the doped passivation layer away from the silicon wafer, through injecting a second reaction gas into the coating device.

2. The method according to claim 1, wherein:
after depositing the doped passivation layer on the back side of the silicon wafer, the method further comprises:
depositing a silicon oxynitride layer at the surface of the doped passivation layer away from the silicon wafer, through injecting the first reaction gas into the coating device; and
depositing the internal reflection layer directly or indirectly on the surface of the doped passivation layer away from the silicon wafer comprises:
depositing the internal reflection layer on a surface of the silicon oxynitride layer away from the doped passivation layer.

3. The method according to claim 2, wherein:
the first reaction gas comprises SiH₄, NH₃, and N₂O, and the doped passivation layer is a doped silicon oxynitride layer;
the second reaction gas comprises SiH₄ and NH₃, and the internal reflection layer is a silicon nitride layer.

4. The method according to claim 3, wherein depositing the internal reflection layer on the surface of the silicon oxynitride layer away from the doped passivation layer comprises:
depositing a plurality of internal reflection layers sequentially stacked on the surface of the silicon oxynitride layer away from the doped passivation layer,
wherein the dopant gas comprises a gas comprising phosphorus, boron, aluminum, gallium, or indium.

5. The method according to claim 4, wherein a refractive index decreases gradually along a direction pointing away from the silicon wafer among the plurality of internal reflection layers.

6. The method according to claim 5, wherein a quantity of internal reflection layers in the plurality of internal reflection layers is three.

7. The method according to claim 6, wherein:
a first internal reflection layer, a second internal reflection layer, and a third internal reflection layer are arranged along the direction pointing away from the silicon oxynitride layer;
the refractive index of the first internal reflection layer ranges from 2.35 to 2.25, and a thickness of the first internal reflection layer ranges from 10nm to 35nm;
the refractive index of the second internal reflection layer ranges from 2.1 to 2.25, and a thickness of the second internal reflection layer ranges from 10nm to 20nm; and
the refractive index of the third internal reflection layer ranges from 1.9 to 2.1, and a thickness of the third internal reflection layer ranges from 10nm to 20nm.

8. The method according to claim 3, wherein:
a fixed negative charge density at a surface of the doped silicon oxynitride layer is greater than or equal to 1×10¹²cm⁻² ; and
a content of hydrogen in the doped silicon oxynitride layer ranges from 18 to 30 in atomic percentage.

9. The method according to any one of claims 1 to 8, wherein before depositing the doped passivation layer on the back surface of the silicon wafer through injecting the dopant gas and the first reaction gas into the coating device, the method further comprises:
polishing the silicon wafer by using an acid solution or an alkali solution.

10. A backside passivation structure of a battery cell, wherein the backside passivation structure is manufactured through the method according to any one of claims 1 to 9.

11. A solar cell, comprising:
the backside passivation structure according to claim 10.
